# EUROPÄISCHE PATENTSCHRIFT

(11) **EP 0 393 587 B1**
(45) Veröffentlichungstag und Bekanntmachung des Hinweises auf die Patenterteilung: **20.07.1994**
(21) Anmeldenummer: 90107262.9
(22) Anmeldetag: 17.04.1990
(51) Int. Cl.: G01R 31/28

(54) **Vorrichtung zum Testen von elektronischen Bauelementen mit einer Ladestation, einer Teststation und einer Entladestation für die Bauelemente**
Device for testing electronic elements with loading station, test station and unloading station for the elements
Dispositif de test pour éléments électroniques avec une station de chargement, une station de test et une station de déchargement pour les éléments

(30) Priorität: 17.04.1989 DE 3912589
(43) Veröffentlichungstag der Anmeldung: 24.10.1990
(73) Patentinhaber: Ueberreiter, Ekkehard, D-83064 Raubling (DE)
(72) Erfinder: Ueberreiter, Ekkehard, D-8201 Raubling (DE); Gentischer, Josef, D-7064 Remshalden (DE)
(74) Vertreter: Schmidt-Evers, Jürgen, Dipl.-Ing.

(56) Entgegenhaltungen:
- DE-A- 3 719 148
- DE-B- 2 130 389

## Beschreibung

Die Erfindung bezieht sich auf eine Vorrichtung nach dem Oberbegriff des Anspruchs 1.

Eine Vorrichtung dieser Art ist in der DE-A-37 19 148 beschrieben und dargestellt. Bei dieser bekannten Ausgestaltung werden die Bauelemente der Teststation mittels des Transportmittels zugeführt und von diesem wieder abgeführt, wobei die Bauelemente während der Zuführung und Abführung in am Transportmittel auswechselbar befestigten Trägern aufgenommen sind.

Das Transportmittel ist durch ein endloses Flachband gebildet, das in einer horizontalen Ebene um zwei in horizontaler Ebene drehbare Räder läuft und an seiner vertikalen Außenfläche in regelmäßigen Abständen voneinander die Träger trägt, mit denen die Bauelemente von der Ladestation zur Teststation und von dieser zur Entladestation transportiert werden. Die Träger weisen jeweils einen vertikalen Schacht auf, in den das zugehörige Bauelement an der Ladestation aufgrund von Schwerkraft aus einem darüber angeordneten Stangenmagazin hineinrutscht. An der Entladestation wird das untere Ende des Schachtes geöffnet, so daß das getestete Bauelement ebenfalls durch Schwerkraft nach unten in einen Führungskanal rutschen kann, der zu einem Stangenmagazin führt. Die Bauelemente weisen unterschiedliche Formen und Abmessungen auf, so daß zu ihrer Aufnahme eine entsprechende Anzahl von Trägertypen mit bauelementspezifischen Schachtausbildungen erforderlich ist. Bei Bedarf werden am Transportmittel befestigte Träger eines Typs gegen Träger eines anderen Typs ausgewechselt.

Die Funktionstüchtigkeit der bekannten Vorrichtung ist insbesondere dadurch beeinträchtigt, daß das Beladen des Transportmittels mit den Bauelementen mit einer Gefahr der Beschädigung der Bauelemente verbunden ist. Diese Gefahr besteht sowohl beim Zuführen der Bauelemente in der Magazinstange als auch beim Beladen des Transportmittels mit den Bauelementen, bei dem das jeweils erste Bauelement vorbewegt werden muß, während gleichzeitig das zweite Bauelement zurückgehalten werden muß, was durch Vereinzelungsvorrichtungen und/oder Bremsvorrichtungen für die Bauelemente erfolgt. Die Gefahr der Beschädigung besteht natürlich auch in vergleichbarer Weise beim Entladen der Bauelemente. Dabei ist zu berücksichtigen, daß es sich bei elektronischen Bauelementen um empfindliche Bauteile handelt, bei denen jede aktive mechanische Berührung eine Gefahr der Beschädigung einschließt. Bei IC's sind insbesondere die kleinen und empfindlichen Anschlußkontakte von der Gefahr des Verbiegens betroffen. Es ist außerdem zu berücksichtigen, daß elektronische Bauelemente aufgrund komplizierter Bauform, wie es auch bei einem IC zutrifft, beim Beladen und Entladen schwierig zu behandeln sind.

Aus der DE-OS 36 38 430 ist es bekannt, IC's mittels eines verfahrbaren Greifers zu ergreifen und einem Tester zuzuführen. Auch bei dieser Ausgestaltung sind Beschädigungen der IC's nicht auszuschließen.

In der DE-B-2 130 389 ist eine Vorrichtung zum Messen verschiedener Kennwerte elektrischer Bauelemente beschrieben. Bei dieser bekannten Vorrichtung handelt es sich um einen Fallschachtautomat, bei dem die zu messenden Bauelemente von Meßposition zu Meßposition fallen. Die Bauelemente, beispielsweise Transistoren, sind vorzugsweise in Trägern angeordnet. Diese bestückten Träger werden beispielsweise in Schienen in horizontaler Lage gestapelt. Die Schienen, aus denen die zu messenden Bauelemente dann in den Automat fallen, sind vorzugsweise auf einer drehbaren Scheibe auf der Oberseite des Meßautomaten befestigt. Jeweils eine dieser Schienen ist über dem Einfallschacht angeordnet. Dieser Einfallschacht ist so geformt, daß in ihm die rahmenförmigen Träger von der horizontalen in die vertikale Lage übergeführt werden, in der sie durch den Meßautomat von Position zu Position fallen. Gemäß einer alternativen Bauweise können die Bauelemente in horizontaler Ebene von einer Meßposition zur nachfolgenden Meßposition bzw. in ein Zwischenmagazin transportiert werden.

Bei dieser bekannten Vorrichtung bilden die Träger selbst das Transportmittel.

Der Erfindung liegt die Aufgabe zugrunde, eine Vorrichtung der eingangs bezeichneten Art so weiterzubilden, daß ihre Funktionstüchtigkeit allgemein verbessert wird und insbesondere der Belade- und Entladevorgang mit geringer Beschädigungsgefahr der Bauelemente durchgeführt werden kann.

Diese Aufgabe wird durch die Merkmale des Anspruchs 1 gelöst.

Erfindungsgemäß werden die jeweils mit einem Bauelement gefüllten Träger an der Ladestation auf das Transportmittel geladen, zur Teststation geführt, um dort geprüft zu werden, anschließend weitertransportiert und an der Entladestation wieder entladen. Bei diesen Vorgängen sind die Bauelemente in den Trägern geschützt angeordnet, so daß eine Beschädigung ausgeschlossen ist. Bei den Trägern handelt es sich dagegen um unempfindliche Teile, die beim Beladen und Entladen zwecks Fortbewegung, Beschleunigung und Abbremsung oder dergl. mit verhältnismäßig wenig Rücksichtnahme beaufschlagt werden können.

Die Befestigungsanordnungen sind vorzugsweise als Eingriffselemente in Form von Nut- und Stegelementen ausgebildet, die es erlauben, das Be- und Entladen einfach und schnell durchzuführen und bei Verwendung von Führungselementen gleicher Form und gleicher Querschnittsabmessungen zu automatisieren.

Das Transportmittel kann als Bandanordnung, beispielsweise in Form eines Bandes oder zweier mit Abstand parallel laufender Bandstreifen, ausgebildet sein.

Um die Bauelemente auf die für die Prüfung an der Teststation erforderliche Temperatur zu temperieren, läuft das Transportmittel vorzugsweise über eine Rollenanordnung in Schleifen durch eine Klimakammer bis zu der am Ende derselben angeordneten Teststation, um gegebenenfalls im Anschluß an die Teststation über eine weitere Rollenanordnung in Schleifen durch eine Akklimatisierungskammer geführt zu werden.

Die Schleifen können offene Schleifen sein, durch die das Transportmittel über Rollen läuft, welche aufeinanderfolgend einen jeweils entgegengesetzten Drehsinn aufweisen. Dabei ist es günstig, wenn zumindest diejenigen Rollen, denen die die Träger tragende Seite des Transportmittels zugewandt ist, mit je einer Umfangsnut als Freiraum zum Eintauchen für die Träger ausgebildet sind.

Vorzugsweise sind die Schleifen geschlossene Schleifen, durch die das Transportmittel entlang schraubenlinienförmiger Bahnen über Rollen gleichen Drehsinns läuft. Auf diese Weise ist es möglich, statt einer vergleichsweise aufwendigen Bandanordnung eine einfache, kommerziell verfügbare Gelenkkette mit Mitnehmerlaschen zu verwenden, an denen die ersten Eingriffsmittel befestigt sind. Statt Rollen mit einer Umfangsnut zur Aufnahme der eintauchenden Träger können einfache Rollen oder einfache Zahnräder verwendet werden, da die Träger stets auf der den Rollen bzw. den Zahnrädern abgewandten Seite des Transportmittels angeordnet sind.

Die Träger können an die Form und Größe unterschiedlicher Bauelemente angepaßt werden, so daß sie sozusagen die Funktion von Adaptern erfüllen, mit denen unterschiedliche Bauelemente auf ein und dasselbe Transportmittel geladen und von diesem entladen werden können. Gemäß einer Weiterbildung der Erfindung sind die ersten Eingriffselemente lösbar am Transportmittel befestigt und können somit zusätzlich oder anstelle der Träger als Adapter verwendet werden, die an die unterschiedlichen Träger angepaßt, jedoch in stets gleicher Weise am Transportmittel befestigt werden.

Vorteilhafte Weiterbildungen der Erfindung, die die Belade-, Entlade- und auch Testfunktion verbessern und bei einfacher und kostengünstiger Ausgestaltung eine sichere Funktion gewährleisten, sind in den verbleibenden Unteransprüchen beschrieben.

Nachfolgend wird die Erfindung anhand bevorzugter Ausführungbeispiele unter Bezugnahme auf die Zeichnung näher erläutert. Es zeigt
- Fig. 1: eine Seitenansicht einer erfindungsgemäßen Vorrichtung zum Testen von elektronischen Bauelementen gemäß einem ersten Ausführungsbeispiel;
- Fig. 2: die in Fig. 1 mit X oder Y gekennzeichnete Einzelheit in vergrößerter Darstellung und in der Draufsicht gemäß einer ersten Ausgestaltung;
- Fig. 3: eine Teilansicht von der Linie III-III in Fig. 2;

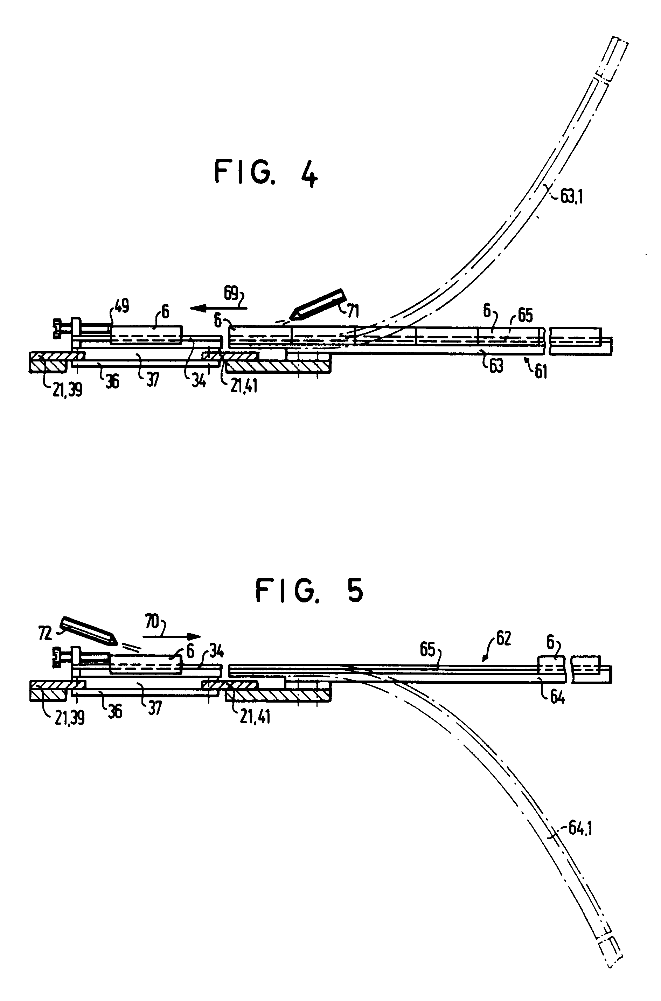

- Fig. 4: den Teilschnitt IV-IV in Fig. 1;
- Fig. 5: den Teilschnitt V-V in Fig. 1;

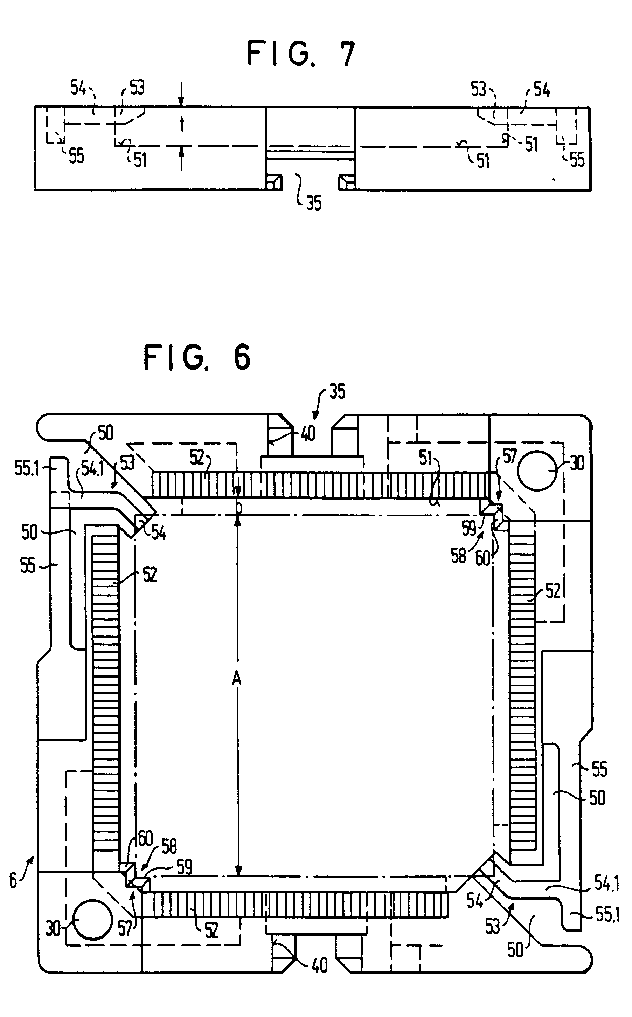

- Fig. 6: einen Träger der Vorrichtung in der Draufsicht;
- Fig. 7: den Träger in der Vorderansicht;
- Fig. 8: ein elektronisches Bauelement in der Draufsicht;
- Fig. 9: das elektronische Bauelement in der Seitenansicht;
- Fig. 10: eine schematische Seitenansicht einer erfindungsgemäßen Vorrichtung zum Testen von elektronischen Bauelementen gemäß einem zweiten Ausführungsbeispiel im Schnitt;
- Fig. 11: einen Schnitt entlang der Linie XI-XI in Fig. 10;
- Fig. 12: eine schematische Seitenansicht einer erfindungsgemäßen Vorrichtung zum Testen von elektronischen Bauelementen gemäß einem dritten Ausführungsbeispiel im Schnitt;
- Fig. 13: einen Schnitt entlang der Linie XIII-XIII in Fig. 12;
- Fig. 14: einen Schnitt entlang der Linie XIV-XIV in Fig. 13 in schematischer Darstellung;
- Fig. 15: eine Seitenansicht einer der Fig. 2 entsprechenden Einzelheit gemäß einer zweiten Ausgestaltung; und
- Fig. 16: einen Schnitt entlang der Linie XVI-XVI in Fig. 15.

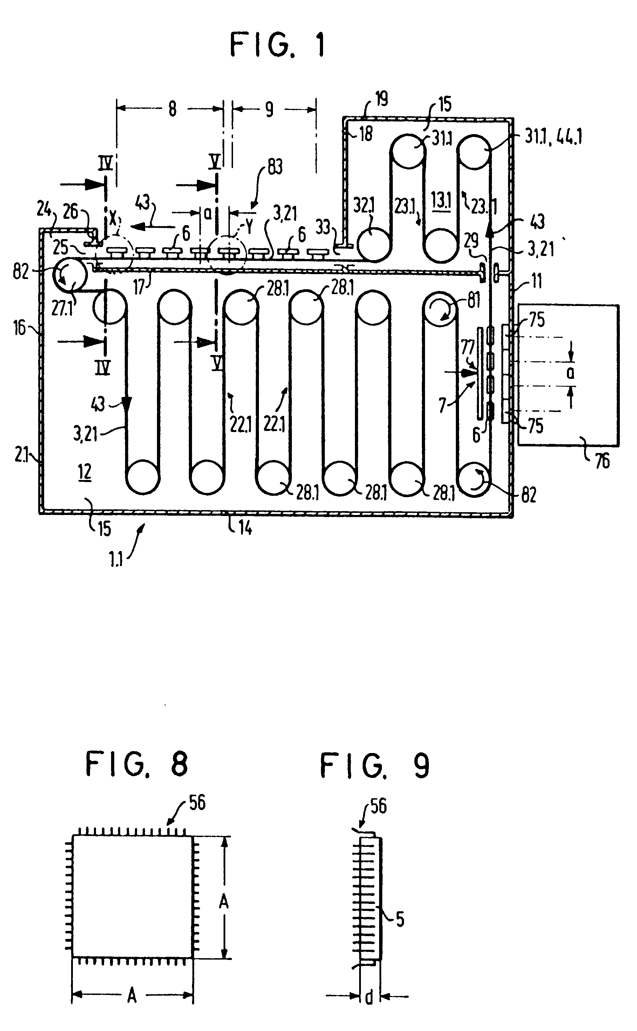

Die wesentlichen Teile der in Fig. 1 dargestellten Einrichtung 1.1 sind ein kastenförmiges, längliches Gehäuse 2.1, in dem ein umlaufendes Transportmittel 3 sich an einer Ladestation 8, an der mit zu prüfenden elektronischen Bauelementen, insbesondere IC's 5 bestückte Träger 6 auf das Transportmittel 3 geladen werden, an einer Teststation 7 zum Testen der IC's 5 und an einer Entladestation 9 zum Entladen der Träger 6 vom Transportmittel 3 vorbeibewegt.

Die Teststation 7 befindet sich an der vertikalen Stirnwand 11 des Gehäuses 2.1, die der Ladestation 8 abgewandt ist, so daß das Transportmittel 3 zwischen der Ladestation 8 und der Teststation 7 eine verhältnismäßig lange Wegstrecke durchläuft. Dies ist dann erwünscht, wenn die IC's 5 beim Testen eine bestimmte Temperatur aufweisen müssen, wobei es sich bezüglich der Normaltemperatur um eine Kühltemperatur oder eine Wärmtemperatur handeln kann.

Zu diesem Zweck weist das Gehäuse 2.1 eine Klimakammer 12 und eine Akklimatisierungskammer 13.1 auf. Die Klimakammer 12 wird durch den unteren quaderförmigen Teil des Gehäuses 2.1 gebildet, mit einer Bodenwand 14, einander gegenüberliegenden vertikalen Seitenwänden 15, der Stirnwand 11, einer dieser gegenüberliegenden vertikalen Stirnwand 16 und einer Deckenwand 17. Die Akklimatisierungskammer 13.1 befindet sich am rechten Ende des Gehäuses 2.1, d.h. oberhalb der Teststation 7, auf dem Gehäuse 2.1, wobei sie durch den rechten Teil der Deckenwand 17 von der Klimakammer 12 getrennt ist. Die Stirn- bzw. Seitenwände der Akklimatisierungskammer 13.1 sind durch eine oberseitige Verlängerung der Stirnwand 11, eine gegenüberliegende Stirnwand 18, oberseitige Verlängerungen der Seitenwände 15 sowie eine diese Wände miteinander verbindende horizontale Deckenwand 19 gebildet.

Das Transportmittel 3 ist gemäß einer ersten Ausgestaltung als ein endloses Flachband 21, vorzugsweise aus Stahl, ausgebildet, das in einer Vertikalebene E um eine Vielzahl Rollen, die mit gegenseitigem Abstand angeordnet und um horizontal und quer zu den Seitenwänden 15 verlaufende Drehachsen frei drehbar sind, umläuft und dabei sowohl in der Klimakammer 12 als auch in der Akklimatisierungskammer 13.1 vertikal angeordnete, offene und mäanderförmig verlaufende Schleifen 22.1, 23.1 bildet, um die Transportzeit in der Klimakammer 12 und in der Akklimatisierungskammer 13.1 so zu vergrößern, daß eine sichere Temperierung und eine Endtemperierung ohne Schock erfolgen kann.

An dem Flachband 21 sind in gleichen Abständen a voneinander die Träger 6 durch Befestigungsanordnungen bestehend aus inneinandergreifenden ersten und zweiten Eingriffselementen gehalten, die ein Laden der Träger 6 auf das Flachband 21 an der Ladestation 8 und ein Entladen an der Entladestation 9 gewährleisten. Die Eingriffselemente sind durch eine quer bzw. rechtwinklig zum Flachband 21 gerichtete lineare Verschiebebewegung des jeweiligen Trägers 6 in Eingriff zu bringen oder wieder zu lösen. Bei den vorliegenden Ausführungsbeispielen ist diese Schiebebewegung horizontal und rechtwinklig zur Vertikalebene E gerichtet, wobei sich diese Verschiebebewegung auch parallel zum Flachband 21 erstreckt.

Zwischen der Akklimatisierungskammer 13.1 und einem am linken Gehäuse-Ende angeordneten Gehäuseaufsatz 24 befinden sich auf der Deckenwand 17 der Klimakammer 12 die Lade- und die Entladestation 8,9 in einer oben offenen Kammer 83, durch die das Flachband 21 in einer horizontalen Ebene hindurchläuft. Dabei gelangt es durch einen horizontalen Schlitz 25 in der rechten Aufsatzstirnwand 26 in den Gehäuseaufsatz 24, wird hier um eine erste, in entsprechender Höhe angeordnete horizontale Auslaufrolle 27.1 nach unten umgelenkt ist, umläuft anschließend mäanderförmig eine Vielzahl oberer und unterer, jeweils zueinander in Gehäuse-Längsrichtung versetzt angeordneter Rollen 28.1 in den vertikalen, offenen Schleifen 22.1, wobei die letzte dieser Rollen 28.1 nahe der unteren rechten Ecke der Klimakammer 12 angeordnet ist, so daß sich das Flachband 21 von dieser Rolle 28.1 etwa parallel zur Stirnwand 16 an der Teststation 7 vorbei vertikal nach oben durch einen entsprechenden Schlitz 29 in der Deckenwand 17 erstreckt, in der Akklimatisierungskammer 13.1 ebenfalls mäanderförmig in den vertikalen, offenen Schleifen 23.1 mehrere obere und untere horizontale Rollen 31.1 S-förmig umschlingt, von denen die letzte, mit 32.1 bezeichnete Rolle als Einlaufrolle zur offenen Kammer 83 im Bereich der unteren linken Ecke der Akklimatisierungskammer 13 angeordnet ist, und sodann durch einen in entsprechender Höhe angeordneten Schlitz 33 waagerecht zur Lade- und Entladestation 7, 8 verläuft, in deren Bereich es durch Gleitschienen vertikal abgestützt sein kann. Der mit dem Uhrzeiger verlaufende Drehsinn 81 der in der Klimakammer 12 in der oberen Reihe angeordneten Rollen 28.1 ist entgegengesetzt dem Drehsinn 82 der Rollen 28.1 in der unteren Reihe. Gleiches gilt für die Rollen 28.1 in der Akklimatisierungskammer 13.1, allerdings mit dem Unterschied, daß die Drehrichtungen 81,82 vertauscht sind. Die Auslaufrolle 27.1 dreht sich bei bewegtem Transportmittel entgegen dem Uhrzeigersinn 82. Die Rollen 28.1 in der Klimakammer 12 bilden eine erste Rollenanordnung und die Rollen 31.1,32.1 in der Akklimatisierungskammer 13.1 eine zweite Rollenanordnung.

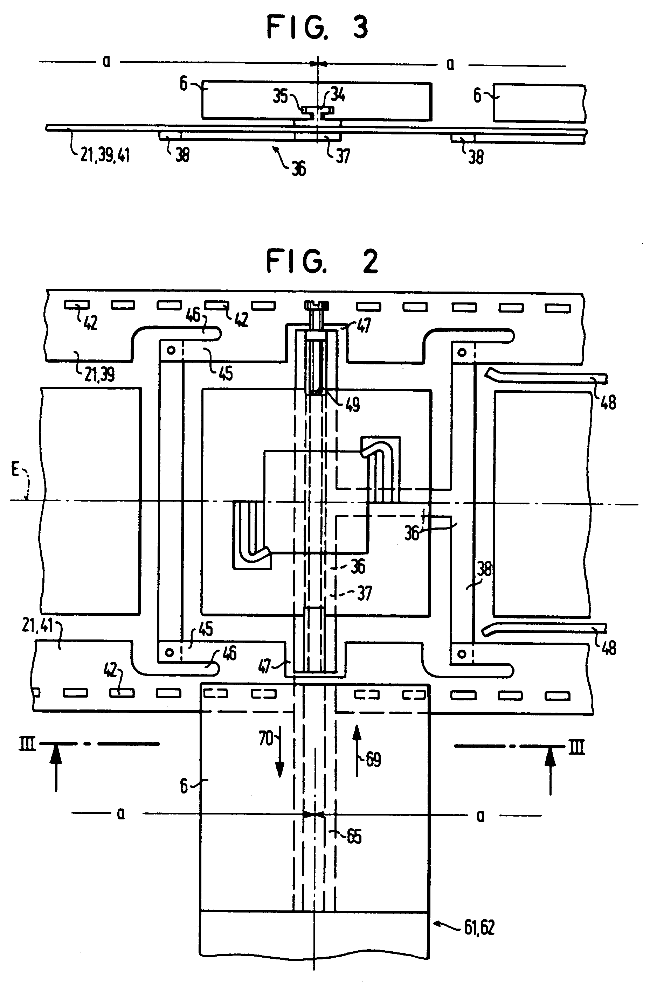

Bei der vorliegenden Ausgestaltung sind die ineinandergreifenden ersten und zweiten Eingriffselemente 34,35 jeweils durch ein T-förmiges, mit seitlichen Vorsprüngen versehenes Stegelement 34 am Flachband 21 und ein entsprechend T-förmig geformtes, den Vorsprüngen des Stegelementes entsprechende Ausbuchtungen aufweisendes Nutelement 35 mit vorzugsweise schrägen Anlaufkanten am Träger 6 gebildet, mit der dieser auf das Stegelement 34 aufschiebbar ist, was am besten in den Fig. 2 und 3 dargestellt ist. Die Stegelemente 34 sind mit den daran gehaltenen Trägern 6 jeweils quer zum Flachband 21 beweglich daran gehalten, damit im Bereich der Flachbandumlenkungen die die Träger 6 haltenden Flachband-Halteteile 36 quer zum Flachband 21 ausweichen können und somit quer anpaßbar sind. Beim vorliegenden Ausführungsbeispiel ist ein H-förmiges Halteteil 36 vorgesehen, dessen einer sich quer zur Vertikalebene E erstreckender Schenkel 37 das Stegelement 34 trägt, und dessen anderer Schenkel 38 mit dem Flachband 21 verbunden ist, wobei der Schenkel 37 um den Schenkel 38 schwenkbar am Flachband 21 gehalten ist.

Beim vorliegenden Ausführungsbeispiel sind aus Materialersparnisgründen zwei parallel zueinander verlaufende Flachbandstreifen 39, 41 vorgesehen, die in gleichen Abständen voneinander aufweisende Eingriffslöcher 42 aufweisen, in die wenigstens an der Antriebs-Rolle angeordnete Zähne eingreifen. Bei der vorliegenden Konstruktion ist die der Teststation 7 in Durchlaufrichtung 43 folgende Rolle die Antriebsrolle 44.1, die sich hier in der oberen rechten Ecke der Akklimatisierungskammer 13.1 befindet. Vorzugsweise ist auch die Rolle 27.1 gleich schnell angetrieben oder mit der Antriebsrolle 44.1 mechanisch gekoppelt.

Der zum Stegelement 34 parallele andere Schenkel 38 ist an seinen Enden an sich längs zum Flachband 21 erstreckenden Zungen 45 der Flachbandstreifen 39, 41 z. B. durch Schrauben, Nieten oder auch Schweißen verbunden, wobei die Zungen durch winkelförmige Schlitzausschnitte 46 in den Flachbandstreifen 39, 41 gebildet sind. Damit auch größere Träger 6 für größere IC's 5 bei gleicher Ausführung der Stegelemente 34 und Nutelemente 35 aufgenommen werden können, sind die Stegelemente 34 länger bemessen als die Träger 6, wobei auf den einander zugewandten Seiten der Flachbandstreifen 39, 41 Ausschnitte 47 vorgesehen sind, in die die freien Enden des Schenkels 37 bzw. des Stegelements 34 eintauchen können. In den Rollen ist durch eine mittlere Umfangsnut ein Freiraum geschaffen, in den hinein sich die Halteteile 36 bewegen können. Zur Begrenzung der Ladebewegung ist am der Ladebewegung entfernten Ende jedes Stegelementes 34 je ein Begrenzungsanschlag 49 vorgesehen, der vorzugsweise verstellbar ist und hier durch eine parallel zum Stegelement 34 angeordnete Einstellschraube gebildet ist, die einen Ansatz auf dem Stegelement 34 in einem Gewindeloch durchfaßt. Jedem Halteteil 36 ist auch ein aus Vereinfachungsgründen nicht dargestelltes Sicherungselement zur Sicherung des Trägers in der aufgeschobenen Ladeposition zugeordnet. Es kann sich hierbei um ein Klemmteil (nicht dargestellt) handeln. Ein solches Sicherungselement kann auch durch seitliche Führungsschienen 48 gebildet sein, die vorzugsweise seitlich einstellbar sind, Einlaufschrägen aufzuweisen und sich mit Ausnahme der Lade- und Entladestation 8, 9 auf dem gesamten Umlaufweg erstrecken können.

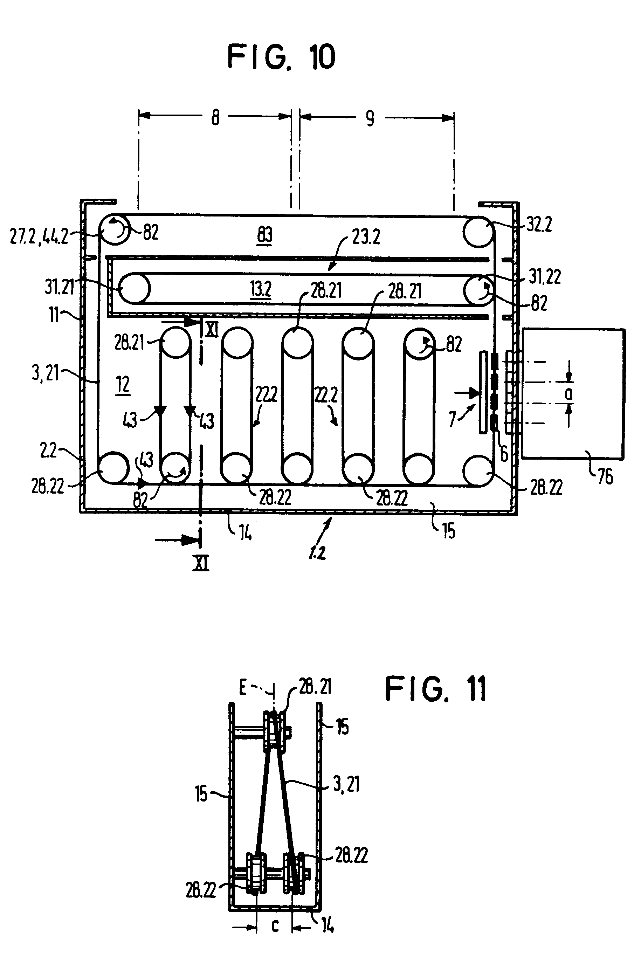

Die Träger 6 sind durch gleiche, plattenförmige und auf dem Flachband 21 flach angeordnete Körper rechteckiger Form gebildet, die an ihrer Unterseite mittig und längs durchgehend das Nutelement 35 und an ihrer Oberseite einen vertikalen Schacht 51 zur Aufnahme der IC's 5 aufweisen. Die Tiefe t des Schachtes 51 entspricht etwa der Dicke d der IC's 5. Der Schacht ist an die Umfangsform der hier durch quadratische Flachkörper 40 gebildeten IC's 5 angepaßt, die mit Ausnahme ihrer Ecken auf ihrem gesamten Umfang sich quer zur Umfangsfläche erstreckende Anschlußkontakte 50 in Form von Drähten aufweisen, vgl. Fig. 8 und 9. Die Anschlußkontakte 50 befinden sich an der Ober- bzw. Bauchseite der IC's 5, und sie tauchen in der eingesetzten Position des IC's in sich quer zum Umfang des Schachtes 51 erstreckende Ausnehmungen oder Riefen 52 am Rand des Schachtes 51 ein, wo sie sicher und beschädigungsfrei aufgenommen sind. Gegen Herausfallen aus dem Schacht 51 ist das IC 5 durch zwei biegsame Sicherungsarme 53 gesichert, die an zwei aneinander gegenüberliegenden Ecken des Schachtes 51 diagonal durch Öffnungen in der Schachtwand in den Schacht 51 hineinragen und dabei die zugehörigen Ecken des IC's 5 vorzugsweise mit Schrägflächen geringfügig übergreifen. Die Sicherungsarme 53 weisen jeweils einen diagonalen Armteil 54 und einen parallel zum Umfang des Trägers 6 und somit einen spitzen Winkel mit dem Armteil 54 einschließenden Armteil 55 auf, der vom Körper des Trägers 6 vorzugsweise einstückig ausgeht. Die Armteile 55 sind über Armteilstücke 54.1 hinaus verlängert, die sich rechtwinklig an den Armteilen 55 erstrecken. Die Verlängerungen sind mit 55.1 bezeichnet. Die Träger 6 bestehen vorzugsweise aus Kunststoff und sind einstückige Druckguß- oder Spritzgußteile, die zum Zweck der Gewichtsverminderung mehrere Aussparungen bzw. Freiräume aufweisen. In solchen Freiräumen 50 sind auch die Sicherungsarme 53 elastisch verbiegbar.

Dem Schacht 51 ist eine besondere vertikale Führung für die IC's 5 zugeordnet, um Beschädigungen der mit Ausnahme im Bereich der Ecken angeordneten Anschlußkontakte 56 der IC's 5 beim Einsetzen in den Träger 6 oder beim Herausnehmen zu vermeiden. Hierzu ist zwischen den einander gegenüberliegenden Schachtwänden und dem Umfang des IC's 5 ein Spalt b vorgesehen. An den beiden anderen Ecken, die zwischen den Sicherungsarmen 53 liegen, ist ein vertikaler Führungsvorsprung 57 mit einer vertikalen winkelförmigen Nutelement 58 angeordnet, deren Form und Abstand voneinander der Form und dem Abstand der zugehörigen Ecken bzw. der Abmessung A des IC's 5 unter Berücksichtigung eines Bewegungsspiels entspricht. Infolgedessen ist das IC 5 lediglich an den beiden winkelförmigen, oberseitig vorzugsweise angeschrägten Führungsflanken 59 und somit nur im Bereich der bzw. dieser Ecken geführt, wo keine Anschlußkontakte 56 vorhanden sind. Die Führungsflanken 59 weisen oberseitig Einführungsschrägen 60 auf. Im Bereich der einander gegenüberliegenden, die Sicherungsarme 53 nicht enthaltenden Ecken jedes Trägers 6 ist je ein rundes Zentrierloch 30 zum Zentrieren des Trägers 6 in der Abgabestelle 12 vorgesehen, in die angespitzte, senkrechte Zentrierstifte an Greifern mit Bewegungsspiel einfassen. An den Enden des Nutelements 35 ist der Träger 6 nach oben durch je eine Ausnehmung 40 ausgespart. Dies ist nicht nur aus spritzgießtechnischen Gründen von Vorteil, sondern es wird auch Freiraum geschaffen für Zentrierwerkzeuge an den Greifern zum Zentrieren des IC's 5 an der Übergabestelle.

An der Ladestation 8 und der Entladestation 9 sind ein Lademagazin 61 bzw. ein Entlademagazin 62 angeordnet, die so mit den Stegelementen 34 fluchten, daß das Beladen aus dem Lademagazin 61 unmittelbar auf das zugehörige Stegelement 34 und das Entladen vom zugehörigen Stegelement 34 unmittelbar in das Entlademagazin 62 möglich ist. Vorzugsweise weisen die Magazine 61, 62 den Eingriffselementen des Flachbandes 21 und der Träger 6 entsprechende Führungselemente auf. Es sind Stangenmagazine vorgesehen, die die Träger 6 durch Führung in den Nutelementen 35 aufnehmen und durch Magazinstangen 63, 64 mit Führungsstegen 65 gebildet sind, deren Querschnittsform den Stegelementen 34 auf dem Flachband 21 entsprechen. Die Magazinstangen 63, 64 können bei gerader bzw. horizontaler Erstreckung gleich ausgebildet sein. Es können auch nach oben leicht gebogene Lade-Magazinstangen 63.1 und leicht nach unten gebogene gekrümmte Entlade-Magazinstangen 64.1 vorgesehen sein mit jeweils einem horizontalem Anschlußschenkel und einem um etwa 45° zu diesem nach oben oder unten leicht abgebogenen Speicherschenkel. Den Lade- und/oder Entlade-Magazinstangen 63, 64 können am Lade- und/oder Entlade-Ende Stopp- oder Bremselemente zugeordnet sein, um den jeweils vordersten und/oder hintersten Träger 6 vorübergehend zu halten, damit die Träger 6 nicht herausrutschen. Die Magazinstangen 63, 64 sind durch angedeutete Stützfüße ortsfest mittelbar oder unmittelbar am Gehäuse 2 in einer mit dem Stegelement 35 fluchtenden Position abgestützt und vorzugsweise mittels einer Schnellschlußverbindung fixiert, so daß sie handhabungsfreundlich ausgetauscht werden können, wenn sie leer bzw. voll sind.

Zum Verschieben der Träger 6 beim Laden und Entladen sind vorzugsweise Lade-Druckluftdüsen 71 und Entlade-Druckluftdüsen 72 vorgesehen, die jeweils in etwa in Lade-Schieberichtung 69 oder Entlade-Schieberichtung 70 weisen und zum Zeitpunkt der Verschiebung kurzzeitig eine auf den vorhandenen Träger 6 gerichtete Druckluftströmung auslassen, die den Träger 6 zwecks Ladung bzw. Entladung verschiebt. Eine Druckluft-Erzeugungsvorrichtung und eine entsprechende Steuerung sind aus Vereinfachungsgründen nicht dargestellt. Die Druckluftdüsen 71, 72 sind wie die Magazinstangen 63, 64 vorzugsweise einstellbar, aber sonst stationär mittelbar oder unmittelbar am Gehäuse 2.1 gehalten. Das Ein- bzw. Ausschießen auf bzw. vom Träger 6 mittels Druckluft ist nicht nur wegen der dadurch erreichbaren Schnelligkeit von Vorteil, sondern es wird insbesondere beim Laden aufgrund der Druckluftströmung eine sichere Anlage des Trägers 6 am zugehörigen Lade-Begrenzungsanschlag 49 erreicht.

Im Bereich der Teststation 7 befindet sich jeweils der Träger 6 in einer vertikalen Position, in der die Öffnung seines Schachtes 51 zum Kontaktteil 75 des zugehörigen Testers 76 offen ist und somit das Kontaktteil 75 mit zugehörigen Kontakten die Anschlußkontakte 50 des betreffenden IC's 5 kontaktieren kann. Dieser Kontakt kann durch eine rechtwinklig zum Flachband 21 gerichtete Bewegung des Trägers 6 bzw. Flachbandes 21 in Richtung auf das Kontaktteil 75 oder durch eine entsprechende Bewegung des Kontaktteils 75 in Richtung auf das Flachband 21 herbeigeführt werden. Bei der vorliegenden Ausgestaltung wird das Flachband 21 bzw. der betreffende Träger 6 mittels eines andeutungsweise auf der dem Kontaktteil 75 abgewandten Seite des Flachbandes 21 angeordneten vor und zurück bewegbaren Schubelementes 77 gegen das Kontaktteil 75 geschoben, wobei die Rückbewegung aufgrund der Spannung im Flachband 21 automatisch erfolgt. Das Kontaktteil 75 und/oder der Tester 76 können an der Stirnwand 11 starr oder aus den vorgenannten Gründen quer zum Flachband 21 beweglich gehalten sein.

Das Flachband 21 wird im Funktionsbetrieb intermittierend um den Abstand a zwischen den Trägern 6 bzw. den Stegelementen 34 vorbewegt und zwar so, daß sich ein jeweiliger Träger 6 in der Ladestation 8, der Teststation 7 und der Entladestation 9 befindet. Im Zuge des Durchlaufs gelangen somit die Träger 6 von der Ladestation 8 zur Teststation 7, wo das Ergebnis der Testung registriert wird, und zur Entladestation 9. Dabei können die Stangenmagazine 63, 64 an einen kontinuierlichen Kreislauf angeschlossen sein, so daß ein Austausch leerer bzw. voller Stangenmagazine 63, 64 nicht erforderlich ist.

Bei der vorliegenden Ausgestaltung sind an der Ladestation 8 vier Lade-Stangenmagazine 63, an der Teststation vier Kontaktteile 75 und an der Entladestation vier Entlade-Stangenmagazine 64 jeweils mit Lade- und Entlade-Druckluftdüsen 69, 70 in dem Abstand a entsprechenden Abständen voneinander vorgesehen, wobei das Flachband 21 jeweils um das Vierfache des Abstands a vorbewegt wird. Auf diese Weise können vier Träger gleichzeitig am Transportmittel befestigt und von diesem entfernt sowie vier IC's 5 gleichzeitig getestet werden. Durch eine Wegfolgespeicherung und -steuerung können IC's 5 unterschiedlicher Qualität nach dem Entladen in nicht dargestellter Weise ausgeschieden werden.

Die in Fig. 10 und 11 dargestellte Einrichtung 1.2 gemäß dem zweiten Ausführungsbeispiel entspricht im wesentlichen der Einrichtung 1.1 nach Fig. 1 mit einem Gehäuse 2.2, dessen unterer Teil eine Klimakammer 12 von gleicher Ausbildung wie die in Fig. 1 gezeigte Klimakammer, jedoch mit einer unterschiedlichen Rollenanordnung 28.2 bildet. Ein weiterer Unterschied gegenüber Fig. 1 besteht darin, daß die hier mit dem Bezugszeichen 13.2 bezeichnete Akklimatisierungskammer zwischen der Klimakammer 12 und der oben offenen Kammer 83, in der sich die Ladestation 8 und die Entladestation 9 befinden, angeordnet ist und ebenfalls eine unterschiedliche Rollenanordnung 31.2 aufweist. Die Kammern 13.2 und 83 stellen den oberen Teil des Gehäuses 2.2 dar und weisen im wesentlichen die gleichen Längen- und Breitenmabmessungen wie die Klimakammern 12 auf.

In der oben offenen Kammer 83 sind mit horizontaler Ausrichtung die Auslauf- und die Einlaufrolle angeordnet, die hier mit dem Bezugszeichen 27.2 bzw. 32.2 bezeichnet sind und das Transportmittel 3 von der Ladestation 8 aus in die Klimakammer 12 hinein bzw. von der Akklimatisierungskammer 13.2 aus in die Kammer 83 zur Entladestation 9 umlenken. Die Auslaufrolle 27.2 ist gleichzeitig als Antriebsrolle 44.2 ausgebildet.

In der Klimakammer 12 sind die Rollen 28.2 als erste Rollen 28.21 mit gegenseitigem Abstand ebenfalls in einer oberen Reihe sowie als zweite Rollen 28.22 in einer unteren Reihe angeordnet. Jede Rolle 28.21 der oberen Reihe bildet zusammen mit je zwei Rollen 28.22 der unteren Reihe eine Rollengruppe. Die Rollen 28.2 jeder Rollengruppe sind mit horizontaler Ausrichtung in einer sich quer zur Gehäuse-Längsrichtung erstreckenden Vertikalebene angeordnet, wobei sich zwischen den koaxial ausgerichteten Rollen 28.22 der unteren Reihe ein Mittenabstand c befindet, der ein gegenseitiges Behindern des die jeweilige Schleife 22.2 durchlaufenden, mit den Trägern 6 beladenen Transportmittels 3 verhindert. Die Umlaufebene E sämtlicher Rollen 28.21 der oberen Reihe halbieren den Mittenabstand c zwischen den Umlaufebenen der Rollen 28.22 der unteren Reihe.

Das Transportmittel 3 umschlingt die Rollen 28.2 jeder Rollengruppe in einer vertikal ausgerichteten, schraubenförmigen, geschlossenen Schleife 22.2, d.h. läuft in Durchlaufrichtung 43 über eine der beiden Rollen 28.22 der unteren Reihe, sodann über die Rolle 28.21 der oberen Reihe und schließlich über die andere der beiden Rollen 28.22 der unteren Reihe, um dann zu der direkt dahinter befindlichen, im gleichen Abstand von der Seitenwand 15 des Gehäuses 2.2 angeordneten Rolle 28.22 der unteren Reihe der nächsten Rollengruppe zu laufen. Dementsprechend weisen sämtliche Rollen 28.2 in der Klimakammer 12 ebenso wie die in der Akklimatisierungskammer 13.2 und oben offenen Kammer 83 befindlichen Rollen 31.2 und 27.2, 32.2 den gleichen Drehsinn 82 entgegen dem Uhrzeiger auf. Vor der ersten und nach der letzten Rollengruppe in der Klimakammer 12 ist je eine weitere Rolle 28.22 in Höhe der unteren Reihe angeordnet.

In der Akklimatisierungskammer 13.2 sind drei Rollen 31.2 in einer in gleicher Weise 31.21,31.22 wie die Rollengruppen in der Klimakammer 12 zusammengesetzten Rollengruppe angeordnet, allerdings in einer horizontalen Ebene, so daß das sie umschlingende Transportmittel 3 eine horizontale, sich über die Gesamtlänge der Akklimatisierungskammer 13.2 erstreckenden Schleife 23.2 bildet.

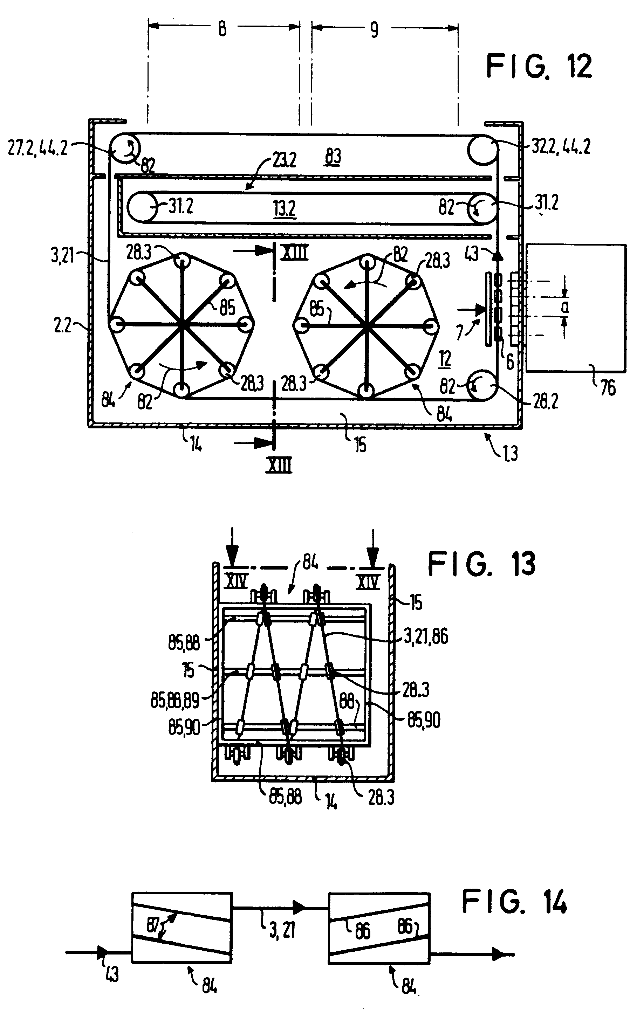

Die in den Fig. 12 bis 14 dargestellte Einrichtung 1.3 gemäß dem dritten Ausführungsbeispiel entspricht im wesentlichen der Einrichtung 1.2 nach den Fig. 10 und 11 mit der gleichen Klimakammer 12, der gleichen Akklimatisierungskammer 13.2 und der gleichen oben offenen Kammer 83 im gleichen Gehäuse 2.2, jedoch mit einer unterschiedlichen Rollenanordnung. Diese unterschiedliche Rollenanordnung umfaßt zwei sternförmige Rollenträger 84 mit radial verlaufenden Armen 85, an deren freien Enden die Rollen 28.3 drehbar gelagert und entlang einer zweifach um den Rollenträger-Umfang umlaufenden Schraubenlinie 86 mit entsprechender Schrägstellung angeordnet sind. Das Transportmittel 3 durchläuft auf diese Weise ebenfalls je eine geschlossene, spiralförmige Schleife 87. Jeder Arm 85 besteht aus einer als Achse für die darauf frei drehbar gelagerte Rolle 28.3 dienenden Querstrebe 88, die von zwei an der Rollenträger-Achse 89 befestigten Stützstreben 90 abgestützt ist. Das Transportmittel 3 läuft von der Auslaufrolle 27.2 in der oben offenen Kammer 83 zum ersten und sodann zum zweiten Rollenträger 84, um von diesen über eine Rolle 28.2 in der für das zweite Ausführungsbeispiel bereits beschriebenen Weise in die Akklimatisierungskammer 13.2 und die oben offene Kammer 83 geführt zu werden. Sämtliche Rollen 27.2,28.2,28.3,31.2 und 32.2 weisen den gleichen Drehsinn 82 entgegengesetzt dem Uhrzeiger auf. Die Rollen 27.2 und 32.2 stellen in diesem Ausführungsbeispiel die Antriebsrollen dar.

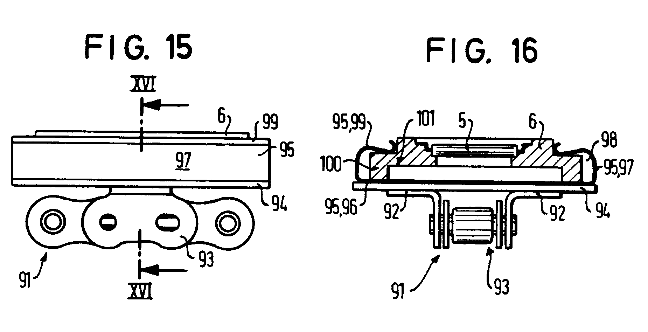

Das Transportmittel 3 ist gemäß der in den Fig. 15 und 16 dargestellten zweiten Ausgestaltung als einfache Rollenkette 91 mit zweiseitigen Winkellaschen 92 ausgebildet, die sowohl über Rollen als auch über Zahnräder (beide nicht gezeigt) geführt werden können. Auf den Winkellaschen 92 von im Abstand a angeordneten Kettengliedern 93 ist je eine Halterungsplatte 94 für das erste Eingriffselement 95 in Form eines hinterschnittenen, T-förmigen Nutelementes in nicht dargestellter Weise befestigt. Das Nutelement 95 ist aus Federstahlblech geformt und besteht aus einem Bodenteil 96 und zwei quer zur Längsrichtung der Kette 91 verlaufenden Nutwandungen 97, an die sich unter Bildung von Ausbuchtungen 98 zwei nach innen gerichtete Schenkel 99 anschließen. Der untere Teil des Trägers 6 bildet zusammen mit zwei seitlich angeformten Vorsprüngen 100 das zweite Eingriffselement 101. Der mit dem elektronischen Bauelement 56 bestückte Träger 6 wird in das Nutelement 95 bis zu einem nicht gezeigten Anschlag eingeschoben, wobei die Vorsprünge 100 innerhalb der Ausbuchtungen 98 angeordnet und durch die elastischen Schenkel 99 in Anlage an das Bodenteil 96 gehalten sind. Zur seitlichen Fixierung des Trägers 6 ist der Abstand zwischen den freien Enden der Schenkel 99 im wesentlichen gleich der Breite des Trägers oberhalb der Vorsprünge 100.

Das Nutelement 95 ist lösbar an der Halterungsplatte 94 befestigt, vorzugsweise durch zwei nicht gezeigte Federklammern, die die in Querrichtung verlaufenden Ränder der Halterungsplatte 94 elastisch umgreifen. Zur Lagefixierung des Nutelementes 95 an der Halterungsplatte 94 können Rastvorsprünge bzw. Rastvertiefungen an beiden Bauelementen ausgebildet sein.

## Patentansprüche

1. Vorrichtung (1) zum Testen von elektronischen Bauelementen (5), inbesondere IC's, mit einem Transportmittel (3), an welchem Träger (6) für die Bauelemente (5) mittels Befestigungsanordnungen (34,35;95,101) lösbar befestigt sind und welches in der Transportrichtung (43) durch eine Ladestation (8) zum Aufnehmen, eine Teststation (7) zum Prüfen und eine Entladestation (9) zum Entfernen der Bauelemente (5) hindurchgeführt ist,
dadurch **gekennzeichnet**,
daß die Befestigungsanordungen (34,35;95,101) erste, am Transportmittel (3) angeordnete Eingriffselemente (34,95) und zweite, an den Trägern (6) angeordnete Eingriffselemente (35;101), beide für den gegenseitigen Eingriff, umfassen, und
daß die Träger (6) zusammen mit den Bauelementen (5) in der Ladestation (8) durch eine quer zur Transportrichtung (43) gerichtete Verschiebebewegung (49) selbsttätig am Transportmittel (3) befestigbar und in der Entladestation (19) durch eine quer oder rechtwinklig zur Transportrichtung (43) gerichtete Verschiebebewegung (49) selbsttätig vom Transportmittel (3) lösbar sind.

2. Vorrichtung nach Anspruch 1,
dadurch **gekennzeichnet,**
daß die Eingriffselemente (34,35;95,101) als Nutelemente (35,95) und mit diesen in Eingriff bringbare Stegelemente (34,101) ausgebildet sind.

3. Vorrichtung nach Anspruch 2,
dadurch **gekennzeichnet,**
daß die Eingriffselemente (34,35;95,101) mit Hinterschneidungen (100,98) ausgebildet sind.

4. Vorrichtung nach Anspruch 3,
dadurch **gekennzeichnet,**
daß die Nutelemente (95) seitliche, von einander zugewandten Schenkeln (99) überdeckte Ausbuchtungen (98) zur Aufnahme von seitlichen Vorsprüngen (100) der Stegelemente (101) umfassen.

5. Vorrichtung nach wenigstens einem der Ansprüche 2 bis 4,
dadurch **gekennzeichnet,**
daß die Nutelemente (35) in den Trägern (6) und die Stegelemente (34) am Transportmittel (3) ausgebildet sind.

6. Vorrichtung nach wenigstens einem der Ansprüche 2 bis 4,
dadurch **gekennzeichnet,**
daß die Stegelemente (101) an den Trägern (6) und die Nutelemente (95) am Transportmittel (3) ausgebildet sind.

7. Vorrichtung nach wenigstens einem der vorhergehenden Ansprüche,
dadurch **gekennzeichnet,**
daß den ersten Eingriffselementen (34) je ein vorzugsweise verstellbares Anschlagteil (49) am Transportmittel (3) zur Begrenzung der Ladebewegung zugeordnet ist.

8. Vorrichtung nach wenigstens einem der vorhergehenden Ansprüche,
dadurch **gekennzeichnet,**
daß wenigstens ein den ersten Eingriffselementen (34) entsprechendes Führungselement (65) an der Lade- und an der Entladestation (8,9) seitlich neben dem Transportmittel (3) angeordnet ist.

9. Vorrichtung nach Anspruch 8,
dadurch **gekennzeichnet,**
daß mehrere Führungselemente (65) lösbar hintereinander gehalten sind und Magazine (63,64) zum Laden und Entladen, vorzugsweise Stangenmagazine, bilden.

10. Vorrichtung nach wenigstens einem der vorhergehenden Ansprüche,
dadurch **gekennzeichnet,**
daß der Ladestation (8) eine Lade-Druckluftdüse (71) zugeordnet ist, die beim Laden einen den vorhandenen Träger (6) in Richtung auf das Transportmittel (3) beaufschlagenden Druckluftstrom abgibt.

11. Vorrichtung nach wenigstens einem der vorhergehenden Ansprüche,
dadurch **gekennzeichnet,**
daß der Entladestation (9) wenigstens eine Entlade-Druckluftdüse (72) zugeordnet ist, die beim Entladen einen auf den vorhandenen Träger (6) gerichteten Druckluftstrom abgibt, der den Träger (6) vom Transportmittel (3) in Entladerichtung (70) herunterschiebt.

12. Vorrichtung nach wenigstens einem der vorhergehenden Ansprüche,
dadurch **gekennzeichnet,**
daß das Transportmittel (3) als eine um Rollen (27,28,31,32) umlaufende biegsame Bandanordnung (21;39,41), insbesondere aus Stahl, eine umlaufende Kette (91), ein Rad, ein verfahrbarer Greifer ausgebildet ist.

13. Vorrichtung nach Anspruch 12,
dadurch **gekennzeichnet,**
daß die Bandanordnung (21;39,41) als Flachband (21) oder als zwei in einem Abstand nebeneinander umlaufende Bandstreifen (39,41) ausgebildet ist.

14. Vorrichtung nach Anspruch 13,
dadurch **gekennzeichnet,**
daß das Band (21) oder die Bandstreifen (39,41) in regelmäßigen Längsabständen Löcher (42) aufweisen, die mit Zähnen an wenigstens einer angetriebenen Rolle kämmen.

15. Vorrichtung nach wenigstens einem der Ansprüche 12 bis 14,
dadurch **gekennzeichnet,**
daß die ersten Eingriffselemente (34) quer zur Ebene der Bandanordnung (21,39,41) ausbiegbar gehalten sind.

16. Vorrichtung nach wenigstens einem der Ansprüche 12 bis 15,
dadurch **gekennzeichnet,**
daß die ersten Eingriffselemente (34) an Längszungen der Bandanordnung (21,39,41) quer ausbiegbar gehalten sind.

17. Vorrichtung nach Anspruch 12,
dadurch **gekennzeichnet,**
daß die Kette (91) als Gelenkkette mit Mitnehmerlaschen (92) ausgebildet ist, an denen die ersten Eingriffselemente (95) befestigt sind.

18. Vorrichtung nach Anspruch 17,
dadurch **gekennzeichnet,**
daß die Gelenkkette (91) als Einfachkette und die Mitnehmerlaschen (92) als Winkellaschen ausgebildet sind.

19. Vorrichtung nach wenigstens einem der vorhergehenden Ansprüche,
dadurch **gekennzeichnet,**
daß die ersten Eingriffselemente (34,95) lösbar am Transportmittel (3) befestigt sind.

20. Vorrichtung nach wenigstens einem der vorhergehenden Ansprüche,
dadurch **gekennzeichnet,**
daß die Teststation (7) in einer Klimakammer (12) angeordnet ist, in welcher das Transportmittel (3) über eine Rollenanordnung (28.1;28.2;28.3) in Schleifen (22.1;22.2;87) zur Teststation (7) geführt ist.

21. Vorrichtung nach wenigstens einem der vorhergehenden Ansprüche,
dadurch **gekennzeichnet,**
daß der Klimakammer (12) eine vom Transportmittel (3) über eine weitere, zweite Rollenanordnung (31.1,32.1;31.2) in Schleifen (23.1;23.2) durchlaufene Akklimatisierungskammer (13.1,13.2) nachgeordnet ist.

22. Vorrichtung nach Anspruch 20 oder 21,
dadurch **gekennzeichnet,**
daß die aufeinanderfolgenden Rollen (28.1;31.1,32.1) der ersten, in der Klimakammer (12) und/oder der zweiten, in der Akklimatisierungskammer (13.1,13.2) angeordneten Rollenanordnung einen jeweils entgegengesetzten Drehsinn (81,82) aufweisen und das Transportmittel (3) offene mäanderförmige Schleifen (22.1;23.1) durchläuft.

23. Vorrichtung nach Anspruch 22,
dadurch **gekennzeichnet,**
daß zumindest diejenigen Rollen (28.1), denen die die Träger (6) tragende Seite des Transportmittels (3) zugewandt ist, mit je einer Umfangsnut als Freiraum zum Eintauchen für die Träger (6) ausgebildet sind.

24. Vorrichtung nach Anspruch 20 oder 21,
dadurch **gekennzeichnet,**
daß die Rollen (28.2,28.3;31.2) der ersten und/oder der zweiten Rollenanordnung den gleichen Drehsinn (82) aufweisen und das Transportmittel (3) geschlossene Schleifen (22.2,87;23.2) entlang schraubenlinienförmiger Bahnen durchläuft.

25. Vorrichtung nach wenigstens einem der Ansprüche 20 bis 24,
dadurch **gekennzeichnet,**
daß das Transportmittel (3) die erste und/oder die zweite Rollenanordnung (28.1,31.1,32.1;28.2;28.3) in im wesentlichen vertikalen Schleifen (22.1,23.1;22.2;87) und/oder im wesentlichen horizontalen Schleifen (23.2) durchläuft.

26. Vorrichtung nach Anspruch 24 oder 25,
dadurch **gekennzeichnet,**
daß sämtliche Rollen (27.2,28.2,28.3,31.2,32.2), über die das Transportmittel (3) läuft, den gleichen Drehsinn (82) aufweisen.

27. Vorrichtung nach wenigstens einem der Ansprüche 24 bis 26,
dadurch **gekennzeichnet,**
daß die erste und/oder die zweite Rollenanordnung (28.2,31.2) wenigstens eine Rollengruppe mit wenigstens einer ersten Rolle (28.21,31.21) und wenigstens zwei zweiten, im Schleifenabstand von der ersten Rolle (28.21,31.21) entfernt angeordneten und gegenseitig beabstandeten (Abstand c) Rollen (28.22,31.22) umfaßt.

28. Vorrichtung nach Anspruch 27,
dadurch **gekennzeichnet,**
daß die zweiten Rollen (28.22,31.22) im wesentlichen koaxial ausgerichtet sind und der Abstand (c) ein gegenseitiges Behindern des die Schleife (22.2,23.2) durchlaufenden, mit den Trägern (6) beladenen Transportmittels (3) verhindert.

29. Vorrichtung nach Anspruch 27 oder 28,
dadurch **gekennzeichnet,**
daß die in der Rollengruppe einander zugeordneten Rollen (28.2) in einer Vertikalebene angeordnet sind.

30. Vorrichtung nach wenigstens einem der Ansprüche 27 bis 29,
dadurch **gekennzeichnet,**
daß die Umlaufebene (E) der ersten Rolle (28.21) der Rollengruppe im wesentlichen halbwegs zwischen den Umlaufebenen der zugeordneten zweiten Rollen (28.22) angeordnet ist.

31. Vorrichtung nach wenigstens einem der Ansprüche 24 bis 26,
dadurch **gekennzeichnet,**
daß die erste und/oder die zweite Rollenanordnung (28.3) wenigstens einen auf einer Rollenträgerachse (89) gehaltenen Rollenträger (84) umfaßt, an welchem die Rollen (28.3) in gleichen Radien mit im wesentlichen gleichen Abständen angeordnet sind.

32. Vorrichtung nach Anspruch 31,
dadurch **gekennzeichnet,**
daß der Rollenträger (84) sternförmig mit einer Anzahl von radial verlaufenden Armen (85) ausgebildet ist, an deren freien Enden die Rollen (28.3) drehbar gelagert sind.

33. Vorrichtung nach Anspruch 31 oder 32,
dadurch **gekennzeichnet,**
daß die Rollen (28.3) des Rollenträgers (84) entlang einer dessen Umfang wenigstens zweimal umlaufenden Schraubenlinie (86) angeordnet sind.

34. Vorrichtung nach wenigstens einem der Ansprüche 31 bis 33,
dadurch **gekennzeichnet,**
daß die Rollen (28.3) des Rollenträgers (84) gegenüber der Rollenträgerachse (89) entsprechend dem Verlauf der Schraubenlinie (86) schräggestellt sind.

35. Vorrichtung nach wenigstens einem der Ansprüche 31 bis 34,
dadurch **gekennzeichnet,**
daß die Rollenträgerachse (89) im wesentlichen horizontal angeordnet ist.

36. Vorrichtung nach wenigstens einem der Ansprüche 31 bis 35,
dadurch **gekennzeichnet,**
daß der Rollenträger (84) drehbar gelagert ist.

37. Vorrichtung nach wenigstens einem der Ansprüche 20 bis 36,
dadurch **gekennzeichnet,**
daß wenigstens eine der Rollen (44.1,44.2) außerhalb der Klimakammer (12) eine angetriebene Rolle ist.

38. Vorrichtung nach wenigstens einem der vorhergehenden Ansprüche,
dadurch **gekennzeichnet,**
daß die Träger (6) einen an ihrer Oberseite ausmündenden Schacht (51) zur Aufnahme der Bauelemente (5) aufweisen.

39. Vorrichtung nach Anspruch 38,
dadurch **gekennzeichnet,**
daß jeweils das im Träger (6) aufgenommene Bauelement (5) durch zwei bezüglich des Schachtes (51) einander gegenüberliegend angeordnete, das Bauelement (5) geringfügig übergreifende und quer zum Schacht (51) ausbiegbare Sicherungsarme (53) gesichert ist.

40. Vorrichtung nach Anspruch 39,
wobei das Bauelement viereckig ist und mit Ausnahme seiner Ecken auf dem gesamten Umfang mit Kontaktelementen (50) bestückt ist,
dadurch **gekennzeichnet,**
daß die Sicherungsarme (53) an einander gegenüberliegenden Ecken des entsprechend geformten Schachtes (51) angeordnet sind.

41. Vorrichtung nach wenigsten einem der Ansprüche 38 bis 40,
dadurch **gekennzeichnet,**
daß die zweiten Eingriffselemente (35,95) auf der dem Eingang des Schachtes (51) entgegengesetzten Seite der Träger (6) angeordnet sind.

42. Vorrichtung nach wenigstens einem der vorhergehenden Ansprüche,
dadurch **gekennzeichnet,** daß die Träger vorzugsweise einstückig gespritzte oder gegossene Kunststoffteile sind.

43. Vorrichtung nach wenigstens einem der Ansprüche 40 bis 42,
dadurch **gekennzeichnet,**
daß die Sicherungsarme (53) sich jeweils in einem Freiraum (50) des Träger-Körpers und durch eine Öffnung in der Schachtwand in den Schacht (51) hinein erstrecken.

44. Vorrichtung nach wenigstens einem der Ansprüche 38 bis 43,
dadurch **gekennzeichnet,**
daß am äußeren Umfangsrand des Schachtes (51) sich quer zum Umfangsrand erstreckende Ausnehmungen (52) zur Aufnahme der Kontaktelemente (50) am Bauelement (5) angeordnet sind, deren Querschnitte einwärts vorzugsweise konvergieren.

45. Vorrichtung nach wenigstens einem der Ansprüche 38 bis 44,
dadurch **gekennzeichnet,**
daß zwischen den im wesentlichen ebenen Wänden des Schachts (51) und dem Bauelement (5) ein Spalt vorgesehen ist und in wenigstens zwei einander gegenüberliegenden Ecken des Schachts (51) vertikale Stege (57) vorgesehen sind, auf deren einander zugewandten Seiten winkelförmige Führungsflächen, vorzugsweise mit Einführungsschrägen (60) für die zugewandten Ecken des IC's (5) vorgesehen sind.

46. Vorrichtung nach wenigstens einem der vorhergehenden Ansprüche,
dadurch **gekennzeichnet,**
daß die Lade- und Entladestation (8,9) an der Oberseite eines die Klimakammer (12) enthaltenden Gehäuses (2.1,2.2) angeordnet sind.

47. Vorrichtung nach Anspruch 46,
dadurch **gekennzeichnet,**
daß die Akklimatisierungskammer (13.1,13.2) als Teil des Gehäuses (2.1,2.2) oberhalb der Klimakammer (12) neben oder unterhalb der Lade- und Entladestation (8,9) angeordnet ist.

48. Vorrichtung nach wenigstens einem der vorhergehenden Ansprüche,
dadurch **gekennzeichnet,**
daß im Bereich der Teststation (7) das Transportmittel (3) durch ein Schubglied (77) quer zu sich selbst in Richtung auf ein Kontaktteil (75) eines in der Teststation (7) befindlichen Testers (76) auslenkbar ist.

49. Vorrichtung nach wenigstens einem der vorhergehenden Ansprüche,
dadurch **gekennzeichnet,**
daß das mit dem zu prüfenden Bauelement (5) in Kontakt bringbare Kontaktteil (75) des Testers (76) in Richtung auf das Transportmittel (3) hin und zurück bewegbar gehalten ist.

50. Vorrichtung nach wenigstens einem der vorhergehenden Ansprüche,
dadurch **gekennzeichnet,**
daß seitliche Führungselemente, vorzugsweise in Form von Führungsstangen oder -streifen (48) zur Lagesicherung der Träger (6) auf dem Transportmittel (3) vorgesehen sind.

51. Vorrichtung nach wenigstens einem der vorhergehenden Ansprüche,
dadurch **gekennzeichnet,**
daß mehrere Ladestationen (8), Teststationen (7) und Entladestationen (9) in wenigstens gleicher Anzahl in Durchlaufrichtung (43) hintereinanderliegend in gleichen Abständen (a) voneinander vorgesehen sind und das Transportmittel (3) in dem Abstand und Anzahl entsprechenden Schrittlängen intermittierend vorbewegbar ist.

## Claims

1. Apparatus (1) for the testing of electronic components (5), in particular IC's, with a transportation device (3) onto which carriers (6) for the components (5) are detachably fastened by means of fastening arrangements (34, 35; 95, 101) and which is passed in the direction of transport (43) through a loading station (8) for loading, a testing station (7) for testing and an unloading station (9) for removal of the components (5),
characterised in that,
the fastening arrangements (34, 35; 95, 101) comprise first engagement elements (34, 95) arranged on the transportation device (3) and second engagement elements (35; 101) arranged on the carriers (6), both for mutual engagement, and in that,
the carriers (6) together with the components (5) are, in the loading station (8), automatically fastenable to the transportation device (3) by means of a displacement movement (49) transverse to the direction of transport (43), and, in the unloading station (19), are automatically detachable from the transportation device (3) by means of a displacement movement (49) transverse or at right angles to the direction of transport (43).

2. Apparatus according to claim 1,
characterised in that,
the engagement elements (34, 35; 95, 101) are formed as groove elements (35, 95) and land elements (34, 101) which can be brought into engagement with the groove elements.

3. Apparatus according to claim 2,
characterised in that,
the engagement elements (34, 35; 95, 101) are formed with undercuts (100, 98).

4. Apparatus according to claim 3,
characterised in that,
the groove elements (95) comprise lateral convexities (98), covered by mutually facing limbs (99), for accommodating lateral protrusions (100) of the land elements (101).

5. Apparatus according to at least one of the claims 2 to 4, characterised in that,
the groove elements (35) are formed in the carriers (6) and the land elements (34) are formed on the transportation device (3).

6. Apparatus according to at least one of the claims 2 to 4,
characterised in that,
the land elements (101) are formed on the carriers (6) and the groove elements (95) are formed on the transportation device (3).

7. Apparatus according to at least one of the preceding claims,
characterised in that,
the first engagement elements (34) have associated therewith respective, preferably adjustable, abutment parts (49) on the transport device (3), for limiting the loading movement.

8. Device according to at least one of the preceding claims,
characterised in that,
at least one guide element (65), corresponding to the first engagement elements (34), is arranged at the loading and unloading stations (8, 9) laterally adjacent the transportation device (3).

9. Apparatus according to claim 8,
characterised in that,
several guide elements (65) are held releasably, one after the other, and form magazines (63, 64) for loading and unloading, preferably stack magazines.

10. Apparatus according to at least one of the preceding claims,
characterised in that,
the loading station (8) has associated therewith a compressed-air nozzle for loading (71), which, upon loading, emits a compressed-air stream acting on one of the carriers (6) in a direction towards the transportation device (3).

11. Apparatus according to at least one of the preceding claims,
characterised in that,
the unloading station (9) has associated therewith at least one compressed-air nozzle for unloading (72), which, upon unloading, emits a compressed-air stream directed at the carrier (6), which displaces the carrier (6) from the transportation device (3) in the direction of unloading (70).

12. Apparatus according to at least one of the preceding claims,
characterised in that,
the transportation device (3) is formed as a flexible band arrangement (21; 39, 41) running around rollers (27, 28, 31, 32), in particular of steel, a circulating chain (91), a wheel, a moveable gripping device.

13. Apparatus according to claim 12,
characterised in that,
the band arrangement (21; 39, 41) is formed as a flat band (21) or as two band strips (39, 41) running spaced apart, side by side.

14. Apparatus according to claim 13,
characterised in that,
the band (21) or the band strips (39, 41) have holes (42) at regular longitudinal intervals which engage with teeth on at least one driven roller.

15. Apparatus according to at least one of the claims 12 to 14,
characterised in that,
the first engagement elements (34) are held deflectable transversely to the plane of the band arrangement (21, 39, 41).

16. Apparatus according to at least one of the claims 12 to 15,
characterised in that,
the first engagement elements (34) are held deflectable transversely on longitudinal tongues of the band arrangement (21, 39, 41).

17. Apparatus according to claim 12,
characterised in that,
the chain (91) is formed as a link-chain with entrainment plates (92) to which the first engagement elements (95) are attached.

18. Apparatus according to claim 17,
characterised in that,
the link-chain (91) is formed as single chain and the entrainment plates (92) are formed as angle plates.

19. Apparatus according to at least one of the preceding claims,
characterised in that,
the first engagement elements (34, 95) are detachably fastened to the transportation device (3).

20. Apparatus according to at least one of the preceding claims,
characterised in that,
the testing station (7) is arranged in a environmental chamber (12), in which the transportation device (3) is guided to the testing station (7) via a roller arrangement (28.1; 28.2; 28.3) in loops (22.1; 22.2; 87).

21. Apparatus according to at least one of the preceding claims,
characterised in that,
an acclimatization chamber (13.1, 13.2), passed through by the transportation device (3) via a further, second roller arrangement (31.1, 32.1; 31.2), in loops (23.1, 23.2), is arranged after the environmental chamber (12).

22. Apparatus according to claim 20 or 21,
characterised in that,
the consecutively arranged rollers (28.1; 31.1, 32.1) of the first roller arrangement, situated in the environmental chamber (12), and/or of the second roller arrangement, situated in the acclimatisation chamber (13.1, 13.2), have respective opposing directions of rotation (81, 82) and the transportation device (3) passes through open, meander-shaped loops (22.1; 23.1).

23. Device according to claim 22,
characterised in that,
at least those rollers (28.1) facing the side of the transportation device (3) which supports the carriers (6) are each formed with a circumferential groove as free space for intrusion of the carriers (6).

24. Apparatus according to claim 20 or 21,
characterised in that,
the rollers (28.2, 28.3; 31.2) of the first and/or the second roller arrangement have the same direction of rotation and the transportation device (3) passes through closed loops (22.2, 87; 23.2) along helix-form paths.

25. Apparatus according to at least one of the claims 20 to 24,
characterised in that,
the transportation device (3) passes through the first and/or second roller arrangement (28.1, 31.1, 32.1; 28.2; 28.3) in essentially vertical loops (22.1, 23.1; 22.2; 87) and/or essentially horizontal loops (23.2).

26. Apparatus according to claim 24 or 25,
characterised in that,
all rollers (27.2, 28.2, 28.3, 31.2, 32.2) over which the transportation device (3) runs have the same direction of rotation (82).

27. Apparatus according to at least one of the claims 24 to 26,
characterised in that,
the first and/or the second roller arrangement (28.2, 31.2) includes at least one group of rollers with at least one first roller (28.21, 31.21) and at least two second rollers (28.22, 31.22) arranged at loop distance from the first roller (28.21, 31.21) and mutually spaced apart (spacing c).

28. Apparatus according to claim 27,
characterised in that,
the second rollers (28.22, 31.22) are directed essentially coaxially and the spacing (c) prevents a mutual hindering of the transportation device (3) passing through the loops (22.2, 23.2) and loaded with the carriers (6).

29. Apparatus according to claim 27 or 28,
characterised in that,
the rollers (28.2) associated with one another in the roller group are arranged in a vertical plane.

30. Apparatus according to at least one of the claims 27 to 29,
characterised in that,
the plane of rotation (E) of the first roller (28.21) of the roller group is positioned essentially halfway between the plane of rotation of the associated second rollers (28.22).

31. Apparatus according to at least one of the claims 24 to 26,
characterised in that,
the first and/or second roller arrangement (28.3) contains at least one roller support (84), held on a roller support axis (89), on which the rollers (28.3) are arranged at equal radiuses and at essentially equal spacings.

32. Apparatus according to claim 31,
characterised in that,
the roller support (84) is formed star-shaped with a number of radially running arms (85), on whose free ends the rollers (28.3) are rotatably mounted.

33. Apparatus according to claim 31 or 32,
characterised in that,
the rollers (28.3) of the roller support (84) are positioned along a helical line (86) which goes around its perimeter at least twice.

34. Apparatus according to at least one of the claims 31 to 33,
characterised in that,
the rollers (28.3) of the roller support (84) are inclined relative to the roller support axis (89), in correspondence to the course of the helical line (86).

35. Apparatus according to at least one of the claims 31 to 34,
characterised in that,
the roller support axis (89) is arranged essentially horizontally.

36. Apparatus according to at least one of the claims 31 to 35,
characterised in that,
the roller support (84) is rotatably mounted.

37. Apparatus according to at least one of the claims 20 to 36,
characterised in that,
at least one of the rollers (44.1, 44.2) positioned outside the environmental chamber (12) is a driven roller.

38. Apparatus according to at least one of the preceding claims,
characterised in that,
the carriers (6) have a well (51) opening on their upper side for receiving the components (5).

39. Device according to claim 38,
characterised in that,
the respective component (5) received by the carrier (6) is secured by two securing arms (53) which are outwardly deflectable transversely of the well (51) and which, relative to the well (51), lie opposite one another, slightly overlapping the component (5).

40. Apparatus according to claim 39,
the component being quadrangular and having contact elements (50) over its entire perimeter with the exception of its corners,
characterised in that,
the securing arms (53) are arranged at opposing corners of the correspondingly shaped well (51).

41. Apparatus according to at least one of the claims 38 to 40,
characterised in that,
the second engagement elements (35, 95) are arranged on the side of the carrier (6) opposed to the entrance of the well (51).

42. Apparatus according to at least one of the preceding claims,
characterised in that,
the carriers are plastics parts, preferably cast or moulded in one piece.

43. Apparatus according to at least one of the claims 40 to 42,
characterised in that,
the securing arms (53) each extend in a free space (50) of the carrier body and reach into the well (51) through an opening in the well wall.

44. Apparatus according to at least one of the claims 38 to 43,
characterised in that,
on the outer perimeter edge of the well (51) there are recesses (52) extending transversely to the perimeter edge, for receiving the contact elements (50) on the component (5), the cross-sections of the recesses preferably converging inwards.

45. Apparatus according to at least one of the claims 38 to 44,
characterised in that,
between the essentially plane walls of the well (51) and the component (5) a gap is provided and in at least two opposing corners of the well (51) vertical lands (57) are provided, on the confronting sides of which angular-shaped guide surfaces are provided, preferably with entry inclinations (60) for the facing corners of the IC's (5).

46. Apparatus according to at least one of the preceding claims,
characterised in that,
the loading and unloading stations (8,9) are positioned on the upper side of a housing (2.1, 2.2) which contains the environmental chamber (12).

47. Apparatus according to claim 46,
characterised in that,
the acclimatisation chamber (13.1, 13.2) is arranged above the environmental chamber (12) as part of the housing (2.1, 2.2) and adjacent to or below the loading and unloading stations (8,9).

48. Apparatus according to at least one of the preceding claims,
characterised in that,
in the region of the testing station (7) the transportation device (3) is deflectable, transversely of itself, towards a contact element (75) of a tester (76) located in the testing station (7), by means of a thrust member (77).

49. Apparatus according to at least one of the preceding claims,
characterised in that,
the contact part (75) of the tester (76) which can be contacted with the component to be tested (5) can be moved forwards and backwards towards the transportation device (3).

50. Apparatus according to at least one of the preceding claims,
characterised in that,
lateral guide elements, preferably in the form of guide bars or strips (48) are provided to secure the position of the carriers (6) on the transportation device (3).

51. Apparatus according to at least one of the preceding claims,
characterised in that,
several loading stations (8), testing stations and unloading stations (9), at least in equal numbers, are provided one after another in the running direction (43) at regular intervals (a), and the transportation device (3) can be advanced intermittently in step lengths corresponding to the interval and number.

## Revendications

1. Dispositif de test pour composants électroniques, en particulier pour circuits intégrés, comprenant un moyen de transport (3) sur lequel des supports (6) pour les composants (5) sont fixés de façon amovible à l'aide d'agencements de fixation (34, 35; 95, 101) et qui passe dans la direction de transport (43) dans une station de chargement (8), une station de test (7) et une station de déchargement (9) respectivement pour prendre, essayer et enlever les composants (5), caractérisé par le fait que les agencements de fixation (34, 35; 95, 101) comprennent des premiers éléments d'engagement (34, 95) disposés sur le moyen de transport (3) et des deuxièmes éléments d'engagement (35, 101) disposés sur les supports (6), les deux en vue de l'engagement réciproque, et que les supports (6), conjointement avec les composants (5), peuvent être fixés à la station de chargement (8) automatiquement au moyen de transport (3) par un mouvement de translation (49) orienté transversalement à la direction de transport (43) et peuvent être séparés à la station de déchargement (19) automatiquement du moyen de transport (3) par un mouvement de translation (49) orienté transversalement ou perpendiculairement à la direction de transport (43).

2. Dispositif suivant la revendication 1, caractérisé par le fait que les éléments d'engagement (34, 35; 95, 101) sont réalisés sous forme d'éléments-rainures (35, 95) et d'éléments-languettes (34, 101) pouvant être amenés en engagement avec ces premiers.

3. Dispositif suivant la revendication 2, caractérisé par le fait que les éléments d'engagement (34, 35; 95, 101) sont réalisés avec des parties en contre-dépouille (100, 98).

4. Dispositif suivant la revendication 3, caractérisé par le fait que les éléments-rainures (95) comprennent des élargissements (98) latéraux, recouverts par des branches (99) se faisant face, pour recevoir des saillies latérales (100) des éléments-languettes (101).

5. Dispositif suivant au moins l'une des revendications 2 à 4, caractérisé par le fait que les éléments-rainures (35) sont formés dans les supports (6) et les éléments-languettes (34) sur le moyen de transport (3).

6. Dispositif suivant au moins l'une des revendications 2 à 4, caractérisé par le fait que les éléments-languettes (101) sont formés sur les supports (6) et les éléments-rainures (95) sur le moyen de transport (3).

7. Dispositif suivant au moins l'une des revendications précédentes, caractérisé par le fait qu'une partie de butée (49) de préférence réglable est associée à chacun des premiers éléments d'engagement (34) sur le moyen de transport (3) en vue de la limitation du mouvement de chargement.

8. Dispositif suivant au moins l'une des revendications précédentes, caractérisé par le fait qu'au moins un élément de guidage (65) correspondant aux premiers éléments d'engagement (34) est disposé, à la station de chargement (8) et à la station de déchargement (9), latéralement à côté du moyen de transport (3).

9. Dispositif suivant la revendication 8, caractérisé par le fait que plusieurs éléments de guidage (65) sont maintenus de façon amovible les uns derrière les autres et forment des magasins (63, 64) pour le chargement et le déchargement, de préférence des magasins à tiges.

10. Dispositif suivant au moins l'une des revendications précédentes, caractérisé par le fait qu'à la station de chargement (8) est associée une buse de chargement à air comprimé (71) qui, lors du chargement, émet un jet d'air comprimé agissant sur le support (6) en direction du moyen de transport (3).

11. Dispositif suivant au moins l'une des revendications précédentes, caractérisé par le fait qu'à la station de déchargement (9) est associée au moins une buse de déchargement à air comprimé (72) qui émet, lors du déchargement, un jet d'air comprimé dirigé sur le support (6) et repoussant le support (6) du moyen de transport (3) dans la direction de déchargement (70).

12. Dispositif suivant au moins l'une des revendications précédentes, caractérisé par le fait que le moyen de transport (3) est réalisé sous la forme d'un agencement de bande (21; 39, 41) flexible passant autour de galets (27, 28, 31, 32), d'une chaîne (91), d'une roue, d'un système de préhension déplaçable.

13. Dispositif suivant la revendication 12, caractérisé par le fait que l'agencement de bande (21; 39, 41) est réalisé sous la forme d'une bande plate (21) ou de deux rubans de bande (39, 41) se déplaçant à distance côte à côte.

14. Dispositif suivant la revendication 13, caractérisé par le fait que la bande (21) ou les rubans de bande (39, 41) présentent, à des intervalles longitudinaux réguliers, des trous (42) engrenant avec les dents d'au moins un galet entraîné.

15. Dispositif suivant au moins l'une des revendications 12 à 14, caractérisé par le fait que les premiers éléments d'engagement (34) sont maintenus de manière à pouvoir être fléchis transversalement au plan de l'agencement de bande (21, 39, 41).

16. Dispositif suivant au moins l'une des revendications 12 à 15, caractérisé par le fait que les premiers éléments d'engagement (34) sont maintenus sur des languettes longitudinales de l'agencement de bande (21, 39, 41) de manière à pouvoir être fléchis transversalement.

17. Dispositif suivant la revendication 12, caractérisé par le fait que la chaîne (91) est réalisée sous forme de chaîne articulée avec des pattes d'entraînement (92) sur lesquelles sont fixés les premiers éléments d'engagement (95).

18. Dispositif suivant la revendication 17, caractérisé par le fait que la chaîne articulée (91) est réalisée sous forme de chaîne simple et les pattes d'entraînement (92) sous forme de pattes coudées.

19. Dispositif suivant au moins l'une des revendications précédentes, caractérisé par le fait que les premiers éléments d'engagement (34, 95) sont fixés de façon amovible au moyen de transport (3).

20. Dispositif suivant au moins l'une des revendications précédentes, caractérisé par le fait que la station de test (7) est disposée dans une chambre climatique (12) dans laquelle le moyen de transport (3) est guidé par un agencement de galets (28. 1; 28. 2; 28. 3) en boucles (22. 1; 22. 2; 87) vers la station de test (7).

21. Dispositif suivant au moins l'une des revendications précédentes, caractérisé par le fait que la chambre climatique (12) est suivie d'une chambre d'acclimatation (13. 1, 13. 2) traversée par le moyen de transport (3) en boucles en passant par un autre deuxième agencement de galets (31. 1, 32. 1; 31. 2).

22. Dispositif suivant la revendication 20 ou 21, caractérisé par le fait que les galets successifs (28. 1; 31. 1, 32. 1) du premier agencement de galets disposé dans la chambre climatique (12) et/ou du deuxième agencement de galets disposé dans la chambre d'acclimatation (13. 1, 13. 2) présentent des sens de rotation opposés (81, 82) et le moyen de transport (3) parcourt des boucles ouvertes en méandres (22. 1; 23. 1).

23. Dispositif suivant la revendication 22, caractérisé par le fait qu'au moins les galets (28. 1) vers lesquels est tourné le côté du moyen de transport (3) portant les supports (6) sont réalisés chacun avec une gorge périphérique permettant le passage des supports (6).

24. Dispositif suivant la revendication 20 ou 21, caractérisé par le fait que les galets (28. 2, 28. 3; 31. 2) du premier et/ou du deuxième agencements de galets présentent le même sens de rotation (82) et le moyen de transport (3) parcourt des boucles fermées (22. 2, 87; 23. 2) suivant des trajectoires en hélice.

25. Dispositif suivant au moins l'une des revendications 20 à 24, caractérisé par le fait que le moyen de transport (3) parcourt le premier et/ou le deuxième agencements de rouleaux (28. 1, 31. 1, 32. 1; 28. 2; 28. 3) en boucles (22. 1, 23. 1; 22. 2; 87) essentiellement verticales et/ou en boucles (23. 2) essentiellement horizontales.

26. Dispositif suivant la revendication 24 ou 25, caractérisé par le fait que tous les galets (27. 2, 28. 2, 28. 3, 31. 2, 32. 2) sur lesquels passe le moyen de transport (3) présentent le même sens de rotation (82).

27. Dispositif suivant au moins l'une des revendications 24 à 26, caractérisé par le fait que le premier et/ou le deuxième agencements de rouleaux (28. 2, 31. 2) comprennent au moins un groupe de galets avec au moins un premier galet 28. 21, 31. 21) et au moins deux seconds galets (28. 22, 31. 22) espacés du premier galet (28. 21, 31. 21) d'une distance correspondant à la distance des boucles et espacés l'un de l'autre (distance c).

28. Dispositif suivant la revendication 27, caractérisé par le fait que les seconds galets (28. 22, 31. 22) sont essentiellement alignés coaxialement et la distance (c) empêche les parties du moyen de transport (3) traversant la boucle (22. 2, 23. 2) et chargées avec les supports (6) de se gêner réciproquement.

29. Dispositif suivant la revendication 27 ou 28, caractérisé par le fait que les galets (28. 2) associés entre eux dans le groupe de galets sont disposés dans un plan vertical.

30. Dispositif suivant au moins l'une des revendications 27 à 29, caractérisé par le fait que le plan de rotation (E) du premier galet (28. 21) du groupe de galets est disposé essentiellement à mi-chemin entre les plans de rotation des seconds galets associés (28. 22).

31. Dispositif suivant au moins l'une des revendications 24 à 26, caractérisé par le fait que le premier et/ou le deuxième agencements de galets (28. 3) comprennent au moins un porte-galets (84) qui est maintenu sur un axe de porte-galets (89) et sur lequel les galets (28. 3) sont disposés sur les mêmes rayons à des distances essentiellement égales.

32. Dispositif suivant la revendication 31, caractérisé par le fait que le porte-galets (84) est réalisé en forme d'étoile avec un nombre de bras radiaux (85) sur les extrémités libres desquels les galets (28. 3) sont montés en rotation.

33. Dispositif suivant la revendication 31 ou 32, caractérisé par le fait que les galets (28. 3) du porte-galets (84) sont disposés le long d'une ligne hélicoïdale (86) passant au moins deux fois sur le pourtour du porte-galets.

34. Dispositif suivant au moins l'une des revendications 31 à 33, caractérisé par le fait que les galets (28. 3) du porte-galets (84) sont inclinés par rapport à l'axe (89) du porte-galets suivant un angle correspondant à l'angle de la ligne hélicoïdale (86).

35. Dispositif suivant au moins l'une des revendications 31 à 34, caractérisé par le fait que l'axe (89) du porte-galets est disposé de façon sensiblement horizontale.

36. Dispositif suivant au moins l'une des revendications 31 à 35, caractérisé par le fait que le porte-galets (84) est monté en rotation.

37. Dispositif suivant au moins l'une des revendications 20 à 36, caractérisé par le fait qu'au moins un des galets (44. 1, 44. 2) à l'extérieur de la chambre climatique (12) est un galet entraîné.

38. Dispositif suivant au moins l'une des revendications précédentes, caractérisé par le fait que les supports (6) présentent un puits (51) débouchant sur le côté supérieur, pour la réception des composants (5).

39. Dispositif suivant la revendication 38, caractérisé par le fait que le composant (5) reçu dans le support (6) est maintenu par deux bras de maintien (53) disposés l'un en face de l'autre par rapport au puits (51), recouvrant légèrement le composant (5) et pouvant être fléchis transversalement au puits (51).

40. Dispositif suivant la revendication 39, le composant étant quadrangulaire et équipé d'éléments de contact (50) sur tout le pourtour, excepté aux coins, caractérisé par le fait que les bras de maintien (53) sont disposés à des coins opposés du puits (51) de forme correspondante.

41. Dispositif suivant au moins l'une des revendications 38 à 40, caractérisé par le fait que les deuxièmes éléments d'engagement (35, 95) sont disposés sur le côté des supports (6) opposé à l'entrée du puits (51).

42. Dispositif suivant au moins l'une des revendications précédentes, caractérisé par le fait que les supports sont des pièces en matière plastique, de préférence injectées ou coulées d'une seule pièce.

43. Dispositif suivant au moins l'une des revendications 40 à 42, caractérisé par le fait que les bras de maintien (53) s'étendent chacun dans un espace libre (50) du corps de support et dans le puits (51) à travers une ouverture dans la paroi du puits.

44. Dispositif suivant au moins l'une des revendications 38 à 43, caractérisé par le fait que sur le bord périphérique extérieur du puits (51), des évidements (52) s'étendant transversalement au bord périphérique sont prévus pour recevoir les éléments de contact (50) sur le composant (5), les sections desdits évidements convergeant de préférence vers l'intérieur.

45. Dispositif suivant au moins l'une des revendications 38 à 44, caractérisé par le fait qu'une fente est prévue entre les parois essentiellement planes du puits (51) et le composant (5) et que dans au moins deux coins opposés du puits (51) sont prévues des branches verticales (57) sur les côtés en regard desquels sont prévues des surfaces de guidage angulaires, de préférence avec des rampes d'introduction (60) pour les angles en regard du circuit intégré (5).

46. Dispositif suivant au moins l'une des revendications précédentes, caractérisé par le fait que la station de chargement (8) et la station de déchargement (9) sont disposées sur le côté supérieur d'une enceinte (2. 1, 2. 2) contenant la chambre climatique (12).

47. Dispositif suivant la revendication 46, caractérisé par le fait que la chambre d'acclimatation (13. 1, 13. 2) est disposée, en tant que partie de l'enceinte (2. 1, 2. 2), au-dessus de la chambre climatique (12) à côté ou en dessous de la station de chargement (8) et la station de déchargement (9).

48. Dispositif suivant au moins l'une des revendications précédentes, caractérisé par le fait que dans la zone de la station de test (7), le moyen de transport (3) peut être dévié par un élément de poussée (77) transversalement à lui-même en direction d'une partie de contact (75) d'un testeur (76) se trouvant à la station de test (7).

49. Dispositif suivant au moins l'une des revendications précédentes, caractérisé par le fait que la partie de contact (75) du testeur (76) pouvant être amenée en contact avec le composant (5) à essayer est maintenue déplaçable de manière à pouvoir être rapproché et écarté du moyen de transport (3).

50. Dispositif suivant au moins l'une des revendications précédentes, caractérisé par le fait que des éléments de guidage latéraux, de préférence sous forme de tiges ou bandes de guidage (48), sont prévus pour maintenir en position les supports (6) sur le moyen de transport (3).

51. Dispositif suivant au moins l'une des revendications précédentes, caractérisé par le fait que plusieurs stations de chargement (8), stations de test (7) et stations de déchargement (9) sont prévues en nombre au moins égal en étant disposées les unes derrière les autres dans la direction de passage (43) à des distances (a) égales les unes par rapport aux autres et que le moyen de transport (3) peut être avancé de façon intermittente par pas correspondant à ladite distance et audit nombre.
